# EUROPEAN PATENT SPECIFICATION

(11) **EP 2 801 780 B1**
(45) Date of publication and mention of the grant of the patent: **18.09.2019**
(21) Application number: 12864294.9
(22) Date of filing: 12.12.2012
(51) Int. Cl.: H01L 23/427, H01L 23/367, F28D 15/02, H05K 7/20

(54) **COOLING DEVICE AND ELECTRONIC DEVICE USING THE SAME**
KÜHLVORRICHTUNG UND ELEKTRONISCHE EINRICHTUNG DAMIT
DISPOSITIF DE REFROIDISSEMENT, ET APPAREIL ÉLECTRONIQUE METTANT EN UVRE CELUI-CI

(30) Priority: 04.01.2012 JP 2012000039
(43) Date of publication of application: 12.11.2014
(73) Proprietor: NEC Corporation, Tokyo 108-8001 (JP)
(72) Inventor: CHIBA, Masaki, Tokyo 1088001 (JP); YOSHIKAWA, Minoru, Tokyo 1088001 (JP); SAKAMOTO, Hitoshi, Tokyo 1088001 (JP); SHOUJIGUCHI, Akira, Tokyo 1088001 (JP); INABA, Kenichi, Tokyo 1088001 (JP); MATSUNAGA, Arihiro, Tokyo 1088001 (JP)
(74) Representative: Vossius & Partner Patentanwälte Rechtsanwälte mbB
(86) International application number: PCT/JP2012/007941
(87) International publication number: WO 2013/102973

(56) References cited:
- JP-A- 2004 085 186
- JP-A- 2005 300 038
- US-A1- 2005 082 158
- US-A1- 2006 185 826

## Description

### TECHNICAL FIELD

The present invention relates to cooling devices for semiconductor devices, electronic equipment and the like and, in particular, to a cooling device and an electronic device using the same employing an ebullient cooling system in which heat transport and heat radiation are performed by a phase-change cycle of vaporization and condensation of a refrigerant.

### BACKGROUND ART

In recent years, with the progress of high performance and high functionality in semiconductor devices, electronic equipment and the like, the amount of heat generation from them has also been increasing. There has been a problem, therefore, that the cooling performance degrades due to a dryout of the operating fluid in the cooling device using a heat pipe in which the operating fluid is circulated by capillary force. In contrast, it is possible to improve the heat transport capability for the cooling device employing the ebullient cooling (thermosiphon) system in which heat transport and heat radiation are performed using the circulation by a phase-change cycle of vaporization and condensation of a refrigerant and the gravity because the refrigerant moves in a state of a gas-liquid two-phase flow. Therefore, it has been expected as a cooling device used for semiconductor devices, electronic equipment and the like with large amount of heat generation.

An example of the cooling device employing the ebullient cooling system (hereinafter, also referred to as "an ebullient cooling device") is described in Patent Literature 1. FIG. 13 is a cross-sectional side view illustrating a configuration of the related ebullient cooling device 500 described in Patent Literature 1. The related ebullient cooling device 500 is used for cooling a semiconductor device 502 as a heat generation source such as a CPU which is mounted on a circuit board 501. The related ebullient cooling device 500 includes an evaporating portion 510 attached on the surface of the semiconductor device 502 and a condenser 520 having a radiator, between which a pair of conduits composed of a vapor conduit 531 and a liquid return conduit 532 are attached. Here, the related ebullient cooling device 500, whose inside is maintained to be a reduced (low) pressure condition of approximately one-tenth of the atmospheric pressure, composes a thermosiphon which enables the refrigerant liquid to circulate without any external power source such as an electric pump by the phase change of water of a liquid refrigerant.

In the related ebullient cooling device 500, the heat generated in the semiconductor device 502 as a heat generation source is transferred to the evaporating portion 510. As a result, the water (Wa) of a liquid refrigerant boils and evaporates by the transferred heat under reduced pressure in the evaporating portion 510, and the generated steam (ST) is conducted from the evaporating portion 510 to the condenser 520 through the vapor conduit 531. In the condenser 520, the refrigerant vapor is cooled by the air (AIR) blown by a cooling fan 540 or the like and becomes liquid (water), which then is circulated again by the gravity to the evaporating portion 510 through the liquid return conduit 532.

Here, the condenser 520 includes a plurality of flat tubes, on which inner wall surfaces a large number of fine grooves are formed. It is said that above-mentioned configuration makes it possible to improve a condensing heat transfer coefficient, to improve the performance of the condenser 520, and therefore to cool the heat generation from a heating element at low cost and efficiently.

Another piece of prior art relevant to the present disclosure is Patent Literature 2 which discloses a cooling device having evaporating means, condensing means, and piping connecting the evaporating means and the condensing means.

### CITATION LIST

### PATENT LITERATURE

Patent Literature 1: Japanese Patent Application Laid-Open Publication No. 2011-047616 (paragraphs [0023] to [0049], and FIG. 1)
Patent Literature 2: US 2005/082158 A1 (WENGER TODD M [US]) 21 April 2005 (2005-04-21).

### DISCLOSURE OF INVENTION

### PROBLEM TO BE SOLVED BY THE INVENTION

Recently, with the growth of data centers or the like to make heavy use of a wide variety of computers such as servers, it has been attempted to make thinner a rack housing electronic devices such as servers. A standard for the size of the rack is set by the Electronic Industries Alliance (EIA), and a minimum unit "1U (Unit)" of the height of the rack is equal to 1.75 inches (44.45 millimeters).

Here, in electronic devices such as servers, a socket or the like to maintain and replace a central processing unit (CPU) is mounted on a board. For this reason, in a low-profile electronic device such as a server mounted in a rack "1U" in height (hereinafter, also referred to as "a 1U server"), the permissible space for a cooling device to cool the CPU is limited to about 25 millimeters in height.

On the other hand, since the related ebullient cooling device adopts a thermosiphon system utilizing the buoyancy of the refrigerant vapor and the gravity of the liquid refrigerant as mentioned above, it is necessary to dispose the condenser above the evaporating portion in the vertical direction. However, when the condenser and the evaporating portion are disposed in the space with about 25 millimeters in height as mentioned above, the circulation of the refrigerant by the gravity is blocked because a sufficient vertical interval cannot be obtained. It becomes difficult, therefore, to obtain the sufficient cooling performance.

In the related ebullient cooling device, the condenser 520 is cooled by the air (AIR) blown by means of a cooling fan 540. But the route of the blow is limited when the related ebullient cooling device is mounted in a low-profile electronic device, and the warm air having absorbed the heat in the condenser 520 results in flowing throughout the electronic device. Consequently, there has been a problem that the cooling efficiency of the entire electronic device decreases.

Thus, there has been a problem that, when the related ebullient cooling device is mounted in a low-profile electronic device, not only is it impossible to obtain the sufficient cooling performance, but also the cooling efficiency of the entire electronic device decreases.

The object of the present invention is to provide a cooling device and an electronic device using the same which solve the problem mentioned above that, when a cooling device employing an ebullient cooling system is mounted in a low-profile electronic device, not only is it impossible to obtain the sufficient cooling performance, but also the cooling efficiency of the entire electronic device decreases.

### MEANS FOR SOLVING A PROBLEM

A cooling device according to an exemplary aspect of the invention includes evaporating means for storing a refrigerant; condensing means for condensing and liquefying a vapor-phase refrigerant vaporized in the evaporation means and radiating heat; a pipe connecting the evaporating means to the condensing means; and flow regulating means for regulating a flow direction of air passing through the condensing means, wherein the evaporating means and the condensing means are located on roughly the same level in the vertical direction; the evaporating means includes an evaporation container and bulkhead means for separating the refrigerant disposed in the evaporation container; the height of the bulkhead means is larger than or equal to the height of a vapor-liquid interface of the refrigerant and is smaller than the height of the evaporation container; the pipe includes a vapor pipe through which vapor-phase refrigerant flows and a liquid pipe through which condensed and liquefied liquid-phase refrigerant flows; the condensing means includes first condensing means and second condensing means which differ in condensing-means height which is defined as the height in vertical direction of a condensation container composing the condensing means, and the condensing-means height of the first condensing means is configured to be larger than the condensing-means height of the second condensing means; the first condensing means includes a vapor pipe connection portion which is connected to the vapor pipe at the position above the condensing-means height of the second condensing means in vertical direction; and the flow regulating means is disposed in the upper part of the second condensing means.

An electronic device according to an exemplary aspect of the invention includes a cooling device; a heating element; and heat radiating means, wherein the cooling device includes evaporating means for storing a refrigerant; condensing means for condensing and liquefying a vapor-phase refrigerant vaporized in the evaporation means and radiating heat; a pipe connecting the evaporating means to the condensing means; and flow regulating means for regulating a flow direction of air passing through the condensing means, wherein the evaporating means and the condensing means are located on roughly the same level in the vertical direction; the evaporating means includes an evaporation container and bulkhead means for separating the refrigerant disposed in the evaporation container; the height of the bulkhead means is larger than or equal to the height of a vapor-liquid interface of the refrigerant and is smaller than the height of the evaporation container; the pipe includes a vapor pipe through which vapor-phase refrigerant flows and a liquid pipe through which condensed and liquefied liquid-phase refrigerant flows; the condensing means includes first condensing means and second condensing means which differ in condensing-means height which is defined as the height in vertical direction of a condensation container composing the condensing means, and the condensing-means height of the first condensing means is configured to be larger than the condensing-means height of the second condensing means; the first condensing means includes a vapor pipe connection portion which is connected to the vapor pipe at the position above the condensing-means height of the second condensing means in vertical direction; and the flow regulating means is disposed in the upper part of the second condensing means; wherein the evaporating means is disposed in the upper part of the heating element and is thermally connected to the heating element, and the condensing means is disposed in the upper part of the heat radiating means and is thermally connected to the heat radiating means.

### EFFECT OF THE INVENTION

According to the cooling device of the present invention, it is possible to obtain a cooling device employing an ebullient cooling system which has the sufficient cooling performance and furthermore can prevent the cooling efficiency of the entire electronic device from decreasing even though it is mounted in a low-profile electronic device.

### BRIEF DESCRIPTION OF THE DRAWINGS

FIG. 1 is a cross-sectional side view illustrating a configuration of a cooling device in accordance with the first exemplary embodiment of the present invention.
FIG. 2 is a diagram illustrating a configuration of a cooling device in accordance with the first exemplary embodiment of the present invention, and is a cross-sectional view taken along the line II-II of FIG. 1.
FIG. 3 is a perspective view illustrating a configuration adjacent to a condenser of a cooling device in accordance with the first exemplary embodiment of the present invention.
FIG. 4 is a top view illustrating a configuration of a cooling device in accordance with the first exemplary embodiment of the present invention.
FIG. 5 is a top view illustrating another configuration of a cooling device in accordance with the first exemplary embodiment of the present invention.
FIG. 6 is a cross-sectional side view illustrating a configuration of a cooling device in accordance with the second exemplary embodiment of the present invention.
FIG. 7 is a cross-sectional side view illustrating a configuration of a cooling device in accordance with the third exemplary embodiment of the present invention.
FIG. 8 is a diagram illustrating a configuration of a cooling device in accordance with the third exemplary embodiment of the present invention, and is a cross-sectional view taken along the line VIII-VIII of FIG. 7.
FIG. 9 is an exploded perspective view illustrating a configuration adjacent to a condenser of a cooling device in accordance with the third exemplary embodiment of the present invention.
FIG. 10 is a diagram illustrating another configuration of a cooling device in accordance with the third exemplary embodiment of the present invention, and is a cross-sectional view taken along the line VIII-VIII of FIG. 7.
FIG. 11 is a cross-sectional side view illustrating a configuration of an electronic device in accordance with the fourth exemplary embodiment of the present invention.
FIG. 12 is a cross-sectional side view illustrating another configuration of an electronic device in accordance with the fourth exemplary embodiment of the present invention.

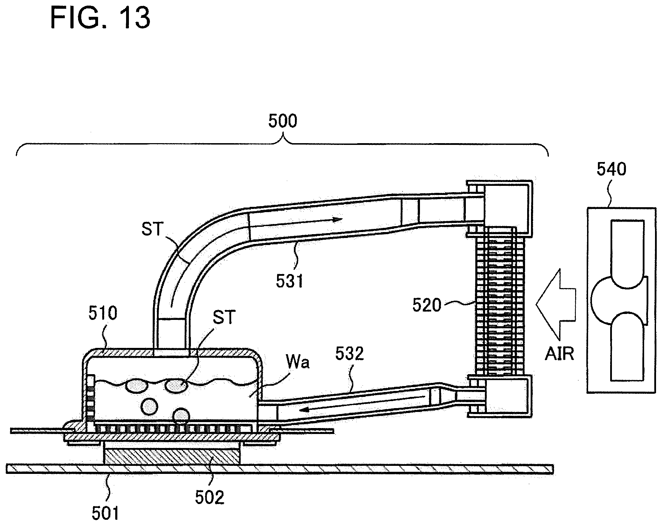

FIG. 13 is a cross-sectional side view illustrating a configuration of a related ebullient cooling device.

### DESCRIPTION OF EMBODIMENTS

The exemplary embodiments of the present invention will be described with reference to the drawings below.

### [The first exemplary embodiment]

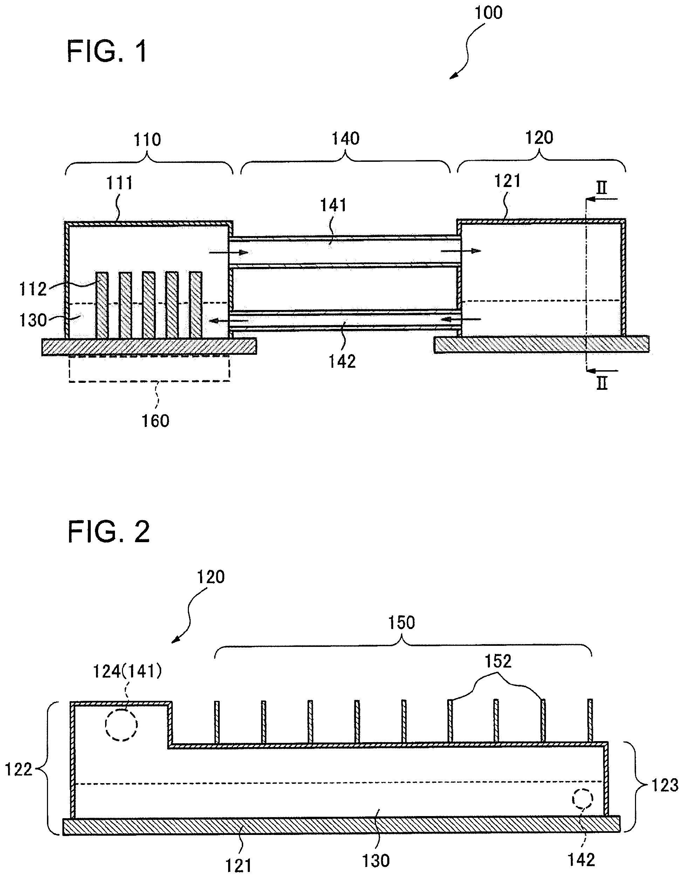

FIG. 1 is a cross-sectional side view illustrating a configuration of a cooling device 100 in accordance with the first exemplary embodiment of the present invention. The cooling device 100 includes an evaporator 110 storing a refrigerant 130, a condenser 120 condensing and liquefying a vapor-phase refrigerant vaporized in the evaporator 110 and radiating heat, and a pipe 140 connecting the evaporator 110 to the condenser 120. It is possible, therefore, to dispose the condenser 120 away from a heating element 160 thermally connected to the evaporator 110. Here, the evaporator 110 and the condenser 120 are located on roughly the same level in the vertical direction. That enables the cooling device 100 to be mounted in a low-profile electronic device with the height of a device restricted.

The evaporator 110 includes an evaporation container 111 and a bulkhead section 112 separating the refrigerant 130 disposed in the evaporation container 111. Here, the height of the bulkhead section 112 is larger than or equal to that of the vapor-liquid interface of the refrigerant 130 and is smaller than that of the evaporation container 111. Here, the vapor-liquid interface of the refrigerant means an interface between the refrigerant in liquid state and the refrigerant in vapor state. The pipe 140 includes a vapor pipe 141 through which vapor-phase refrigerant flows and a liquid pipe 142 through which condensed and liquefied liquid-phase refrigerant flows.

It is possible to keep the pressure within the evaporation container 111 equal to a saturated vapor pressure of the refrigerant 130 constantly by using a low-boiling material as the refrigerant 130 and evacuating the evaporation container 111 after having injected the refrigerant 130 into it. In FIG. 1, a hatched portion in the evaporator 110 and the condenser 120 represents the refrigerant in liquid state, and a dotted line in the hatched portion represents the vapor-liquid interface of the refrigerant 130. It is possible to use as the refrigerant 130 a low-boiling refrigerant such as hydrofluorocarbon and hydrofluoroether which are insulating and inactive materials, for example. As the materials composing the evaporator 110 and the condenser 120, it is possible to use the metal having an excellent thermal conductive property such as aluminum and copper.

Next, a configuration adjacent to the condenser 120 will be described in more detail. FIG. 2 is a cross-sectional view taken along the line II-II of FIG. 1. The condenser 120 includes a first condenser 122 and a second condenser 123 which differ in condenser height which is defined as the height in vertical direction of the condensation container 121 composing the condenser 120. Here, the condenser height of the first condenser 122 is configured to be larger than that of the second condenser 123. The first condenser 122 includes a vapor pipe connection portion 124 which is connected to the vapor pipe 141 at the position above, in vertical direction, the condenser height of the second condenser 123. Moreover, the cooling device 100 according to the present exemplary embodiment includes a flow regulating unit 150 which is disposed on the upper surface of the second condenser 123. The flow regulating unit 150 regulates a flow direction of the air passing through the condenser 120. According to the cooling device 100 configured as described above, it becomes possible to dispose the flow regulating unit 150 securing the volume occupied by the refrigerant in vapor state (refrigerant vapor) in the condenser 120 without increasing the condenser height.

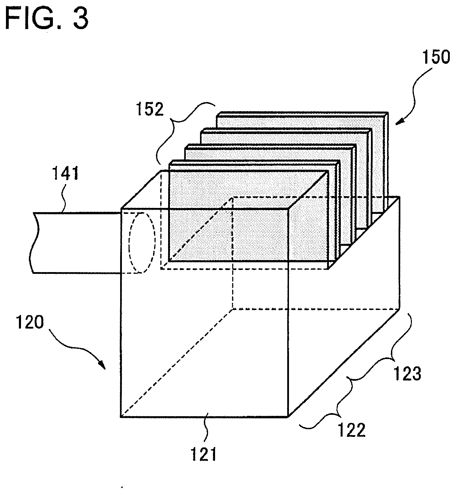

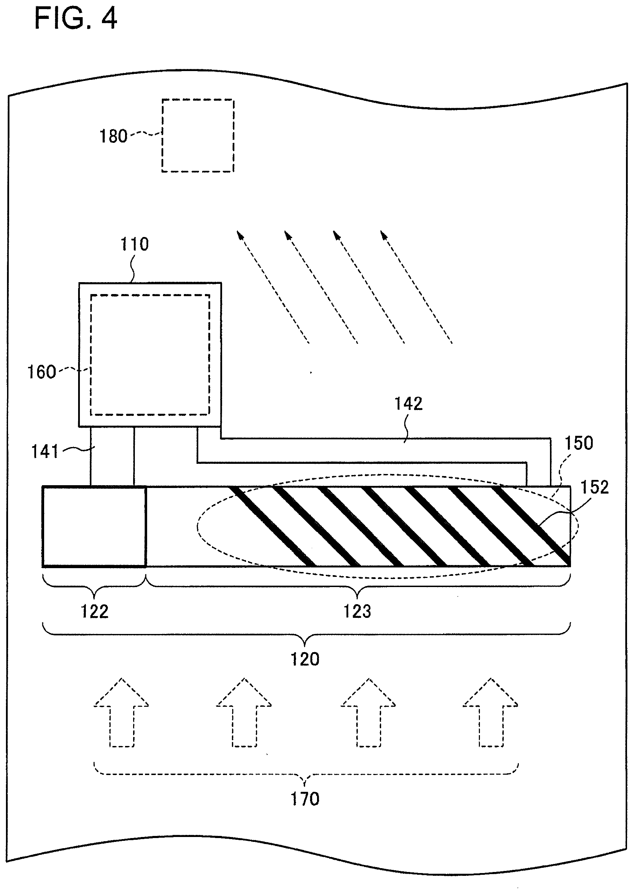

An example of a specific configuration of the flow regulating unit 150 is illustrated in FIGS. 3 and 4. FIG. 3 is a perspective view illustrating a configuration adjacent to the condenser 120 in the cooling device 100 according to the present exemplary embodiment. FIG. 4 is a top view illustrating a configuration of the cooling device 100 according to the present exemplary embodiment. As shown in FIGS. 3 and 4, the flow regulating unit 150 can be configured to include a plurality of flow regulating thin plates 152 with rectangle-shaped thin plates standing. At this time, part of the air (cooling air 170) flowing into the condenser flows along the flow regulating thin plates 152. The cooling air 170 can be configured to be blown by a cooling fan to cool an electronic device in which the cooling device 100 is mounted, for example.

As shown in FIG. 4, the flow regulating thin plates 152 can be disposed so that their drawing directions may be inclined to the inflow direction of the air (cooling air 170) flowing into the condenser 120. This enables to change the flow direction of the cooling air from the direction in which to flow into the condenser 120 to an intended direction. In an example shown in FIG. 4, the flow direction of the cooling air is changed to the direction (dashed-line arrows in FIG. 4) toward a heat generating component 180 which is disposed in downstream direction diagonally behind the cooling device 100. Although this enables part of the cooling air 170 to absorb heat passing through the condenser 120 and to flow reaching a state of warm air, the other part of the cooling air 170 which has passed through the flow regulating unit 150 reaches the heat generating component 180 with it holding cool. It is possible, therefore, to cool efficiently also the heat generating component 180 composing the electronic device. The examples of the heat generating component 180 include a CPU peripheral element (chip set) with its permissible temperature range (temperature margin) small.

As described above, according to the cooling device 100 in the present exemplary embodiment, the heating element 160 thermally connected to the evaporator 110 is cooled by radiating the heat in the condenser 120. And it becomes possible to cool another heat generating component 180 which is mounted in the electronic device by the cooling air whose flow direction is controlled by the flow regulating unit 150. That is to say, according to the present exemplary embodiment, it is possible to obtain the cooling device 100 which has the sufficient cooling performance and furthermore can prevent the cooling efficiency of the entire electronic device from decreasing even though it is mounted in a low-profile electronic device.

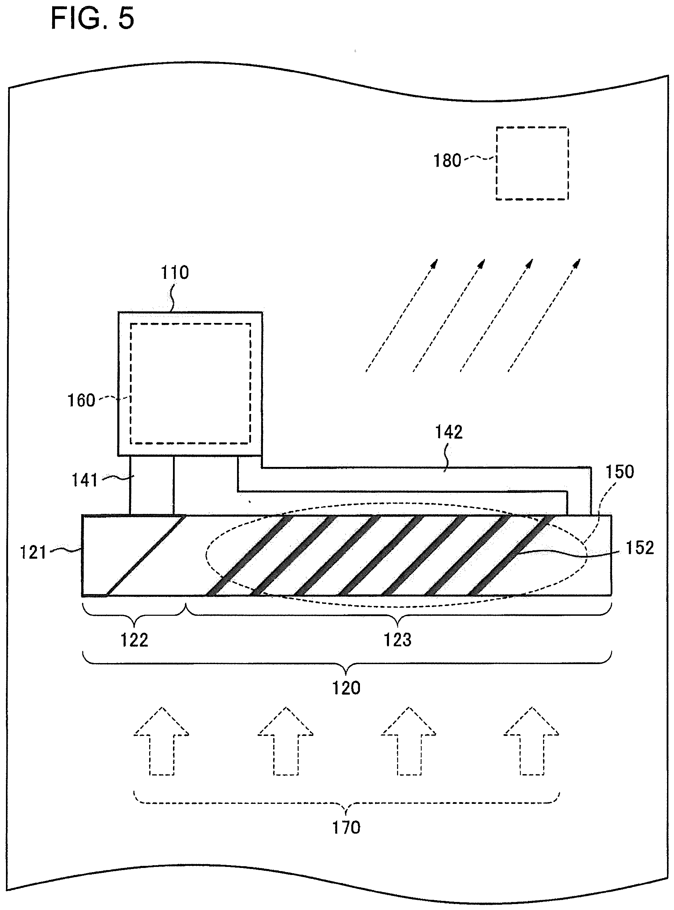

The configuration of the flow regulating unit 150 is not limited to that shown in FIG. 4, and it is possible to configure the flow regulating thin plates 152 so that the cooling air can flow in a direction toward the location where the heat generating component 180 is disposed. At this time, as shown in FIG. 5, it is also acceptable that the side surface of the condensation container 121 at the boundary region between the first condenser 122 and the second condenser 123 is configured to be inclined to the inflow direction of the air flowing into the condenser 120. This further accelerates the flow of the cooling air in a direction toward the location where a heat generating component is disposed.

Next, the operation of the cooling device 100 in accordance with the present exemplary embodiment will be described in detail. As shown in FIG. 1, the cooling device 100 is used disposing the heating element 160 such as a central processing unit (CPU) at the bottom of the evaporator 110, thermally connected to the evaporator 110. It is possible to obtain a good thermal connection by mounting the evaporator 110 and the heating element 160 through a heat-conducting material such as grease. The heat from the heating element is conducted to the refrigerant 130 through the evaporation container 111 of the evaporator 110, so that the refrigerant 130 vaporizes. At this time, since the heat from the heating element is drawn by the refrigerant as vaporization heat, the increase in temperature of the heating element is suppressed.

The injected amount of the refrigerant 130 is determined so that it may be larger than or equal to the amount calculated from the amount of heat generation of the heating element 160 and the vaporization heat of the refrigerant and that the height of the vapor-liquid interface of the refrigerant 130 may be shorter than or equal to the height of the bulkhead section 112. The height of the bulkhead section 112 can be set so that a space between about 5 and 10 millimeters in height may be disposed between the upper edge of the bulkhead section 112 and the top board of the evaporation container 111.

The refrigerant vapor evaporated in the evaporator 110 expands in volume from liquid phase and fills the evaporation container 111, and a pressure difference occurs within the evaporation container 111 due to the presence of the bulkhead section 112. That is to say, since the height of the bulkhead section 112 is larger than or equal to the height of the vapor-liquid interface of the refrigerant 130, there exists the refrigerant vapor also in the area of the bulkhead section 112. In the area of the bulkhead section 112, however, the volume of the refrigerant vapor is limited because the refrigerant vapor is separated by the bulkhead section 112. Therefore, the pressure of the refrigerant vapor in the area of the bulkhead section 112 is larger than that in the area between the upper edge of the bulkhead section 112 and the top board of the evaporation container 111. Here, the bulkhead section 112 can be configured to include a plurality of bulkhead thin plates (fins) with rectangle-shaped thin plates standing. At this time, the volume occupied by the refrigerant vapor in the area of the bulkhead section 112 is limited due to spacing between the bulkhead thin plates (fins).

On the other hand, in the condenser 120, the refrigerant vapor is cooled due to contact with the condensation container 121 and the like and is condensed and liquefied. Since the refrigerant vapor rapidly reduces the volume with a phase-change into liquid, the pressure of vapor-phase refrigerant within the condensation container 121 becomes lower than that within the evaporation container 111. Consequently, the pressure gradient of the refrigerant vapor occurs among the bulkhead section 112 of the evaporator 110, the area between the upper edge of the bulkhead section 112 and the top board of the evaporation container 111, and the condensation container 121, in this order. According to the cooling device 100 of the present exemplary embodiment, therefore, since the evaporator 110 and the condenser 120 are located on roughly the same level in the vertical direction, it becomes possible to transport the refrigerant vapor from the evaporator 110 to the condenser 120 even though the circulation of the refrigerant vapor by buoyancy is unavailable.

The vapor-liquid interface of the refrigerant in the evaporator 110 lowers because the liquid-phase refrigerant vaporizes and breaks away turning into bubbles in the evaporator 110. However, the liquid-phase refrigerant is immediately supplied to the evaporator 110 from the condenser 120 through the liquid pipe 142 so that the vapor-liquid interface of the refrigerant in the evaporator 110 and the condenser 120 can be kept constant. This enables the liquid-phase refrigerant to circulate between the evaporator 110 and the condenser 120 even though the circulation of the liquid-phase refrigerant by the gravity is unavailable because the evaporator 110 and the condenser 120 are located on roughly the same level in the vertical direction.

As described above, the pipe 140 is configured to include the vapor pipe 141 through which the vapor-phase refrigerant flows and the liquid pipe 142 through which the liquid-phase refrigerant condensed and liquefied flows. It is preferable that the vapor pipe 141 should be configured to be connected to the evaporation container 111 at the position higher than or equal to the height of the bulkhead section 112. It is preferable that the liquid pipe 142 should be configured to be connected to each of the evaporation container 111 and the condensation container 121 at the position lower than or equal to the height of the vapor-liquid interface of the refrigerant. Such a configuration makes it possible to accelerate the circulation of refrigerant.

As mentioned above, according to the cooling device 100 of the present exemplary embodiment, it is possible to obtain a cooling device employing an ebullient cooling system which has the sufficient cooling performance even though it is necessary to dispose the evaporator 110 and the condenser 120 on roughly the same level in the vertical direction, for example, even though mounted in a low-profile electronic device.

### [The second exemplary embodiment]

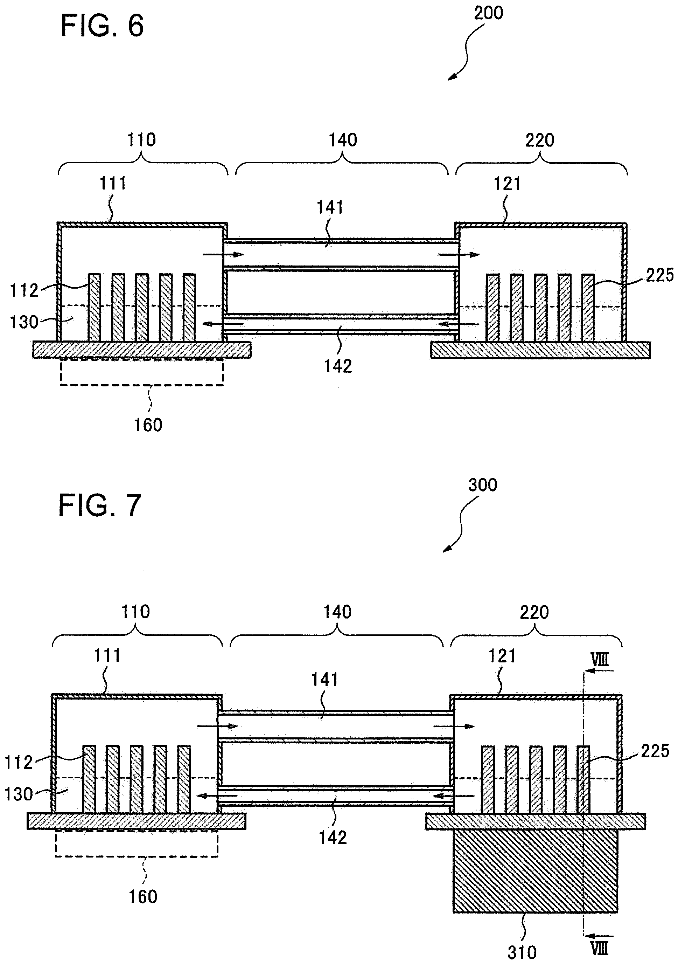

Next, the second exemplary embodiment of the present invention will be described. FIG. 6 is a cross-sectional side view illustrating a configuration of a cooling device 200 in accordance with the second exemplary embodiment of the present invention. The cooling device 200 includes the evaporator 110 storing the refrigerant 130, a condenser 220 condensing and liquefying a vapor-phase refrigerant vaporized in the evaporator 110 and radiating heat, and a pipe 140 connecting the evaporator 110 to the condenser 220. Here, the evaporator 110 and the condenser 220 are located on roughly the same level in the vertical direction. The evaporator 110 includes the evaporation container 111 and a bulkhead section 112 separating the refrigerant 130 disposed in the evaporation container 111, and the height of the bulkhead section 112 is larger than or equal to that of the vapor-liquid interface of the refrigerant 130 and is smaller than that of the evaporation container 111. The pipe 140 includes the vapor pipe 141 through which vapor-phase refrigerant flows and a liquid pipe 142 through which condensed and liquefied liquid-phase refrigerant flows.

The condenser 220 includes the first condenser 122 and the second condenser 123 which differ in the condenser height which is defined as the height in vertical direction of the condensation container 121 composing the condenser 220. Here, the condenser height of the first condenser 122 is configured to be larger than that of the second condenser 123. The first condenser 122 includes the vapor pipe connection portion 124 which is connected to the vapor pipe 141 at the position above, in vertical direction, the condenser height of the second condenser 123. Moreover, the cooling device 200 according to the present exemplary embodiment includes the flow regulating unit 150 which is disposed on the upper surface of the second condenser 123. The flow regulating unit 150 regulates a flow direction of the air passing through the condenser 220.

The cooling device 200 according to the present exemplary embodiment differs from the cooling device 100 of the first exemplary embodiment in the configuration of the condenser 220, and the other configurations are the same, and therefore, the detailed description about them is omitted. The condenser 220 includes a condensing plate unit 225 accelerating the heat radiation of vapor-phase refrigerant in the condensation container 121. Since the condensing plate unit 225 accelerates cooling, condensing and liquefying the refrigerant vapor in the condenser 220, it is possible to further improve the cooling performance of the cooling device 200.

In order to condense and liquefy efficiently the refrigerant vapor generated in the evaporator 110 by the condensing plate unit 225, it is preferable that the condensing plate unit 225 should have a large surface area. The condensing plate unit 225, therefore, can be configured to include a plurality of condensing thin plates (fins) with rectangle-shaped thin plates standing. In order to dispose the condensing plate unit 225 not only in the first condenser 122 but also in the second condenser 123, it is preferable that the height of the condensing plate unit 225 should be configured to be lower than the condenser height of the second condenser 123.

As mentioned above, according to the cooling device 200 of the present exemplary embodiment, since the condensing plate unit 225 disposed within the condensation container 121 accelerates cooling, condensing and liquefying the refrigerant vapor, it is possible to further improve the cooling performance. And it becomes possible to cool another heat generating component 180 which is mounted in the electronic device by the cooling air whose flow direction is controlled by the flow regulating unit 150. That is to say, according to the present exemplary embodiment, it is possible to obtain the cooling device 200 which has the sufficient cooling performance and furthermore can prevent the cooling efficiency of the entire electronic device from decreasing even though it is mounted in a low-profile electronic device.

### [The third exemplary embodiment]

Next, the third exemplary embodiment according to the present invention will be described. FIG. 7 is a cross-sectional side view illustrating a configuration of a cooling device 300 according to the third exemplary embodiment of the present invention. The cooling device 300 includes the evaporator 110 storing the refrigerant 130, the condenser 220 condensing and liquefying a vapor-phase refrigerant vaporized in the evaporator 110 and radiating heat, and a pipe 140 connecting the evaporator 110 to the condenser 220. Here, the evaporator 110 and the condenser 220 are located on roughly the same level in the vertical direction. The evaporator 110 includes the evaporation container 111 and a bulkhead section 112 separating the refrigerant 130 disposed in the evaporation container 111, and the height of the bulkhead section 112 is larger than or equal to that of the vapor-liquid interface of the refrigerant 130 and is smaller than that of the evaporation container 111. The condenser 220 is configured to include the condensing plate unit 225 accelerating the heat radiation of vapor-phase refrigerant within the condensation container 121. The pipe 140 includes the vapor pipe 141 through which vapor-phase refrigerant flows and a liquid pipe 142 through which condensed and liquefied liquid-phase refrigerant flows.

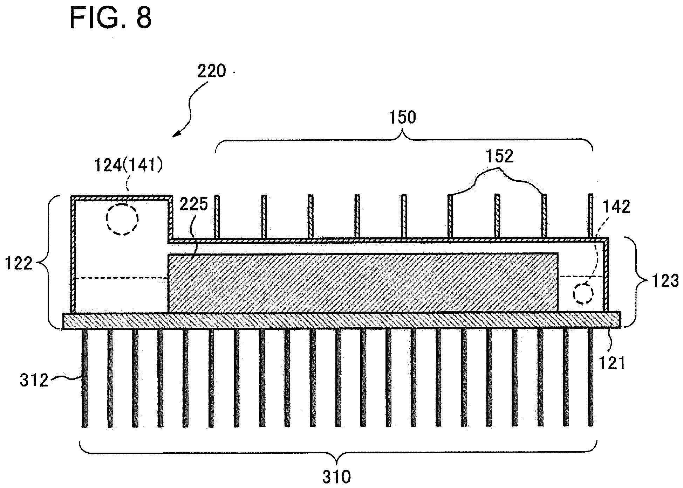

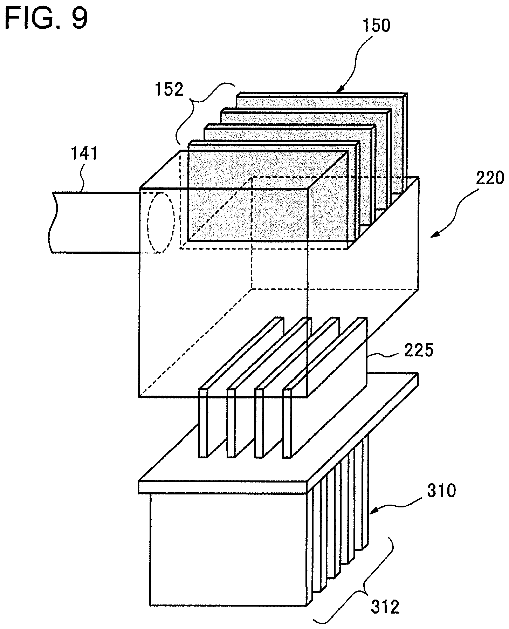

Next, a configuration adjacent to the condenser 220 will be described in more detail. FIG. 8 is a cross-sectional view taken along the line VIII-VIII of FIG. 7. FIG. 9 is an exploded perspective view illustrating a configuration adjacent to the condenser 220 of the cooling device 300 according to the present exemplary embodiment.

The condenser 220 includes the first condenser 122 and the second condenser 123 which differ in the condenser height which is defined as the height in vertical direction of the condensation container 121 composing the condenser 220. Here, the condenser height of the first condenser 122 is configured to be larger than that of the second condenser 123. The first condenser 122 includes the vapor pipe connection portion 124 which is connected to the vapor pipe 141 at the position above, in vertical direction, the condenser height of the second condenser 123. Moreover, the cooling device 300 includes the flow regulating unit 150 which is disposed on the upper surface of the second condenser 123. The flow regulating unit 150 includes a plurality of flow regulating thin plates 152 with rectangle-shaped thin plates standing and regulates a flow direction of the air passing through the condenser 220. In the present exemplary embodiment, the condenser 220 is configured to include the condensing plate unit 225 accelerating the heat radiation of vapor-phase refrigerant within the condensation container 121.

The cooling device 300 according to the present exemplary embodiment differs from the cooling device 200 according to the second exemplary embodiment in further including a heat radiating unit 310 thermally connected to the condenser 220. The other configurations are the same as those in the second exemplary embodiment, and therefore, the detailed description about them is omitted here. As shown in FIGS. 8 and FIG. 9, the heat radiating unit 310 is disposed at the bottom of the condenser 220 and can be configured to include a plurality of heat radiating thin plates 312 with rectangle-shaped thin plates standing. The heat radiating thin plate 312 typically has a fin shape, and can be formed by using the metal having an excellent thermal conductive property such as aluminum and copper. The heat radiating unit 310 and the condensing plate unit 225 can be formed as a unit, or can be thermally connected to each other after having been formed independently.

Here, the cooling device 300 according to the present exemplary embodiment can be configured so that a distance between every two adjacent ones of the flow regulating thin plates 152 may be larger than a distance between every two adjacent ones of the heat radiating thin plates 312. By this configuration, the plurality of flow regulating thin plates 152 and the plurality of heat radiating thin plates 312 can effectively fulfill their respective functions that the plurality of flow regulating thin plates 152 control a flow direction of the air passing through the condenser 220 and that the plurality of heat radiating thin plates 312 accelerating cooling the refrigerant vapor in the condenser 220. Specifically, for example, the distance of the flow regulating thin plates 152 is about 7 millimeters, and the distance of the heat radiating thin plates 312 is about 2 millimeters.

By this heat radiating unit 310, cooling, condensing and liquefying of refrigerant vapor in the condenser 220 are accelerated, and thus, it is possible to further improve the cooling performance of the cooling device 300. Moreover, according to the cooling device 300 of the present exemplary embodiment, even though the evaporator 110 and the condenser 220 are configured to be located on roughly the same level in the vertical direction, it is possible to circulate the refrigerant. Therefore, the heat radiating unit 310 can be disposed at the bottom of the condenser 220 which is located at the same side as that of the heating element 160. Accordingly, it is unnecessary to ensure another area in order to install the heat radiating unit 310, and therefore, it becomes possible to mount the cooling device 300 in a low-profile electronic device.

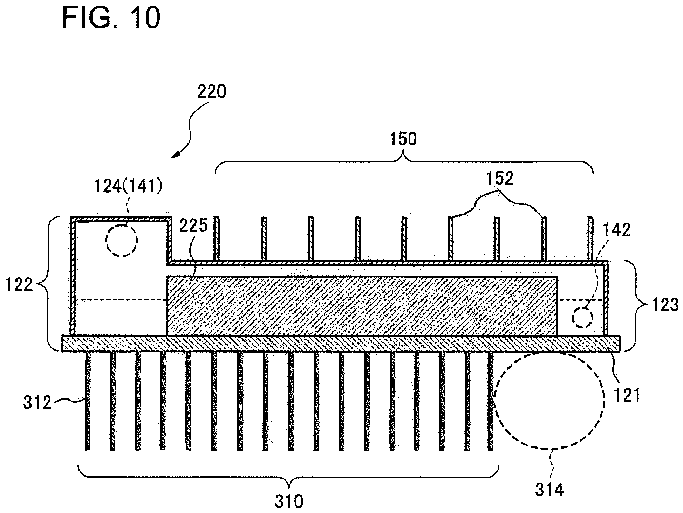

In addition, in FIG. 8, there is illustrated a case where, as the configuration of the heat radiating unit 310, the heat radiating thin plates 312 are disposed across the entire area below the condenser 220. However, it is not limited to this, the heat radiating unit 310 can be also configured to include a blower area 314 where any of the heat radiating thin plates 312 is not disposed. For example, as shown in FIG. 10, the configuration can be made so that the blower area 314, in which any of the heat radiating thin plates 312 is not disposed, is included in an area neighboring a position connected to the liquid pipe 142. In the blower area 314, cooling air 170 passes through a vicinity of the heat radiating unit 310 with it holding cool without receiving heat from the heat radiating thin plates 312. Thus, it becomes also possible to cool heat generating components existing on an extension of a flow direction of cooling air. That is to say, heat generating components existing on an extension of a flow direction of cooling air are not cooled by cooling air whose flow direction is controlled by the flow regulating unit 150, but are cooled by part of the cooling air 170 which passes through the blower area 314.

As described above, according to the cooling device 300 of the present exemplary embodiment, the heat radiating unit 310, which is thermally connected to the condenser 220, accelerates cooling as well as condensing and liquefying of refrigerant vapor, and therefore, it is possible to further improve the cooling performance. And it becomes possible to cool other heat generating components which are mounted in an electronic device by using cooling air whose flow direction is controlled by the flow regulating unit 150. That is to say, according to the cooling device 300 of the present exemplary embodiment it is possible to realize a cooling device which has the sufficient cooling performance and furthermore can prevent the cooling efficiency of the entire electronic device from decreasing even though it is mounted in a low-profile electronic device.

### [The fourth exemplary embodiment]

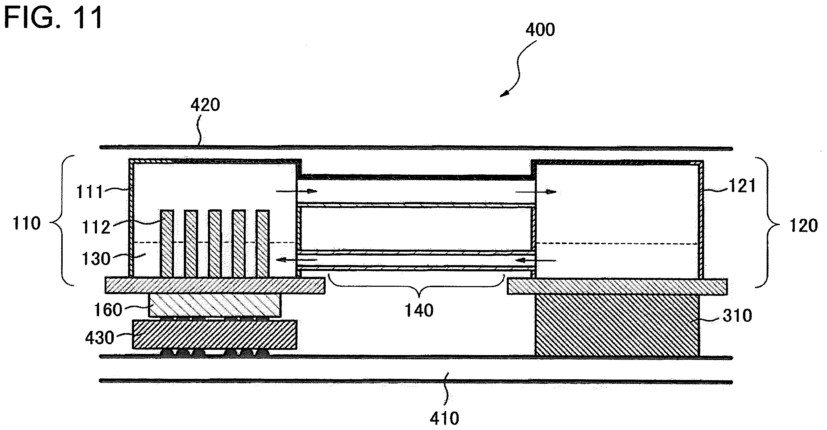

Next, the fourth exemplary embodiment according to the present invention will be described. FIG. 11 is a cross-sectional side view illustrating a configuration of an electronic device 400 according to the fourth exemplary embodiment of the present invention. The electronic device 400 includes a cooling device, a heating element 160, and a heat radiating unit 310. The configuration of this cooling device is the same as that of the cooling device 100 according to the first exemplary embodiment. That is to say, the cooling device 100 includes an evaporator 110 storing refrigerant 130, a condenser 120 in which heat radiation is performed by condensing and liquefying vapor-phase refrigerant evaporated by the evaporator 110, a pipe 140 connecting between the evaporator 110 and the condenser 120, and a flow regulating unit 150 regulating a flow direction of air passing through the condenser 120. Here, the evaporator 110 and the condenser 120 are located on roughly the same level in the vertical direction. The evaporator 110 includes an evaporation container 111 and a bulkhead section 112 separating the refrigerant 130 contained in the evaporation container 111, and the height of the bulkhead section 112 is larger than or equal to the height of the vapor-liquid interface of the refrigerant 130 and is smaller than the height of the evaporation container 111. The pipe 140 includes a vapor pipe through which vapor-phase refrigerant flows and a liquid pipe through which condensed and liquefied liquid-phase refrigerant flows.

The condenser 120 includes a first condenser and a second condenser which differ in condenser height which is defined as the height in vertical direction of the condensation container composing the condenser 120, and the condenser height of the first condenser is configured to be higher than the condenser height of the second condenser. The first condenser includes a vapor pipe connection portion connected to the vapor pipe at the position above, in vertical direction, the condenser height of the second condenser. Here, the flow regulating unit 150 is disposed at a position above the second condenser.

In the electronic device 400 according to the present exemplary embodiment, the evaporator 110 is disposed at a position above the heating element 160 so as to be thermally connected thereto, and the condenser 120 is disposed at a position above the heat radiating unit 310 so as to be thermally connected thereto.

The electronic device 400 is, for example, a server or the like including a central processing unit (CPU) as the heating element 160, and is disposed on a substrate 410 and is installed in a chassis 420. The heat generating 160, such as a CPU, is mounted on the substrate 410 in the state being loaded into a socket 430 or the like. The evaporator 110 is mounted at a position above the heating element 160 via a heat conduction member therebetween, such as grease. Meanwhile, the condenser 120 connected to the evaporator 110 via the pipe 140 is disposed together with the heat radiating unit 310 at a position distanced from the heating element 160. Further, heat from the heating element 160 is thermally transported in conjunction with the movement of the refrigerant 130 as a vapor-liquid two phase flow, so that the heating element 160 is cooled. And it becomes possible to cool other heat generating components mounted in the electronic device by using cooling air whose flow direction is controlled by the flow regulating unit 150.

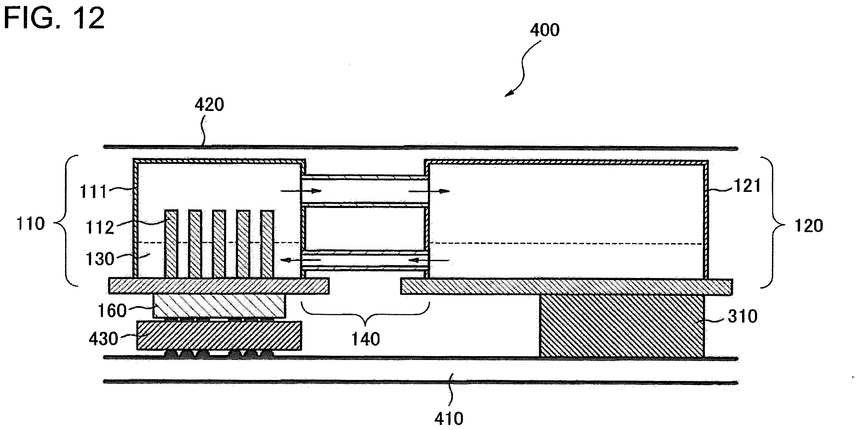

FIG. 11 illustrates the configuration in which the condenser 120 and the heat radiating unit 310 have substantially the same width. However, the configuration of the electronic device 400 is not limited to this, and may be made such that, for example, as shown in FIG. 12, the width of the condenser 120 is extended in a direction towards the evaporator 110. In this way, since the capacity of the condenser 120 is increased, the volume of vapor-phase refrigerant is also increased. As a result, the elevation of a boiling point of the refrigerant due to the increase of internal pressure of the cooling device 100 is eased, and thereby, the suppression of vaporization of liquid-phase refrigerant in the evaporator 110 can be prevented. Thus, it becomes possible to realize further improvement of the cooling performance of the cooling device 100.

As described above, according to the electronic device 400 of the present exemplary embodiment, it is possible to, when the evaporator 110 and the condenser 120 are disposed at positions of substantially the same height in a vertical direction, realize a cooling device employing an ebullient cooling method, which is superior in a heat transportation capability. Thus, even when, for example, a target electronic device is a low-profile electronic device adapted to a rack having a height of 1U (44.45 millimeters), it is possible to achieve the sufficient cooling performance. Moreover, it is possible to prevent the degradation of a cooling efficiency of the entire electronic device.

### DESCRIPTION OF THE CODES

- 100, 200, 300: cooling device
- 110: evaporator
- 111: evaporation container
- 112: bulkhead section
- 120, 220: condenser
- 121: condensation container
- 122: first condenser
- 123: second condenser
- 124: vapor pipe connection portion
- 130: refrigerant
- 140: pipe
- 141: vapor pipe
- 142: liquid pipe
- 150: flow regulating unit
- 152: flow regulating thin plate
- 160: heating element
- 170: cooling air
- 180: heat generating component
- 225: condensing plate unit
- 310: heat radiating unit
- 312: heat radiating thin plate
- 314: blower area
- 400: electronic device
- 410: substrate
- 420: chassis
- 430: socket
- 500: related ebullient cooling device
- 501: circuit board
- 502: semiconductor device
- 510: evaporating portion
- 520: condenser
- 531: vapor conduit
- 532: liquid return conduit
- 540: cooling fan

## Claims

1. A cooling device, comprising:
evaporating means for storing a refrigerant;
condensing means for condensing and liquefying a vapor-phase refrigerant vaporized in the evaporation means and radiating heat;
a pipe connecting the evaporating means to the condensing means; and
flow regulating means for regulating a flow direction of air passing through the condensing means,
wherein the evaporating means and the condensing means are located on roughly the same level in the vertical direction;
the evaporating means comprises an evaporation container and bulkhead means for separating the refrigerant disposed in the evaporation container;
the height of the bulkhead means is larger than or equal to the height of a vapor-liquid interface of the refrigerant and is smaller than the height of the evaporation container;
the pipe comprises a vapor pipe through which vapor-phase refrigerant flows and a liquid pipe through which condensed and liquefied liquid-phase refrigerant flows;
**characterised in that**
the condensing means comprises first condensing means and second condensing means which differ in condensing-means height which is defined as the height in vertical direction of a condensation container composing the condensing means, and the condensing-means height of the first condensing means is configured to be larger than the condensing-means height of the second condensing means;
the first condensing means comprises a vapor pipe connection portion which is connected to the vapor pipe at the position above the condensing-means height of the second condensing means in vertical direction; and
the flow regulating means is disposed in the upper part of the second condensing means.

2. The cooling device according to claim 1,
wherein the flow regulating means comprises a plurality of flow regulating thin plates with rectangle-shaped thin plates standing, and
a drawing direction of the flow regulating thin plates is inclined to an inflow direction of air flowing into the condensing means.

3. The cooling device according to claim 1 or 2,
wherein the vapor pipe is connected to the evaporation container at a position higher than or equal to the height of the bulkhead means, and
the liquid pipe is connected to the evaporation container at a position lower than or equal to the height of the vapor-liquid interface of the refrigerant.

4. The cooling device according to any one of claims 1, 2, and 3,
wherein the bulkhead means comprises a plurality of bulkhead thin plates with rectangle-shaped thin plates standing.

5. The cooling device according to any one of claims 1, 2, 3, and 4,
wherein the condensing means comprises condensing plate means for accelerating heat radiation of the vapor-phase refrigerant in the condensation container;
the condensing plate means comprises a plurality of condensing thin plates with rectangle-shaped thin plates standing; and
the height of the condensing plate means is lower than the condensing-means height of the second condensing means.

6. The cooling device according to any one of claims 1, 2, 3, 4, and 5,
wherein the liquid pipe is connected to the condensation container at a position lower than or equal to the height of the vapor-liquid interface of the refrigerant.

7. The cooling device according to any one of claims 1, 2, 3, 4, 5, and 6, further comprising heat radiating means thermally connected to the condensing means,
wherein the heat radiating means is disposed in the lower part of the condensing means.

8. The cooling device according to claim 7,
wherein the flow regulating means comprises a plurality of flow regulating thin plates with rectangle-shaped thin plates standing,
the heat radiating means comprises a plurality of heat radiating thin plates with rectangle-shaped thin plates standing; and
a distance between the flow regulating thin plates is larger than a distance between the heat radiating thin plates.

9. The cooling device according to any one of claims 1, 2, 3, 4, 5, 6, 7, and 8,
wherein a side surface of the condensation container at a boundary region between the first condensing means and the second condensing means is inclined to the inflow direction of air flowing into the condensing means.

## Patentansprüche

1. Kühlvorrichtung, mit:
einem Verdampfungsmittel zum Speichern eines Kältemittels;
einem Kondensationsmittel zum Kondensieren und Verflüssigen eines im Verdampfungsmittel verdampften Dampfphasen-Kältemittels und zum Abstrahlen von Wärme;
einer Leitung, die das Verdampfungsmittel mit dem Kondensationsmittel verbindet; und
einem Durchflussregelmittel zum Regeln einer Strömungsrichtung der Luft, die durch das Kondensationsmittel strömt,
wobei das Verdampfungsmittel und das Kondensationsmittel in die vertikale Richtung annähernd auf derselben Höhe angeordnet sind;
das Verdampfungsmittel einen Verdampfungsbehälter und ein Trennwandmittel zum Trennen des im Verdampfungsbehälter angeordneten Kältemittels aufweist;
die Höhe des Trennwandmittels größer oder gleich der Höhe einer Dampf-Flüssigkeits-Grenzfläche des Kältemittels und kleiner als die Höhe des Verdampfungsbehälters ist;
die Leitung eine Dampfleitung, durch die Dampfphasen-Kältemittel strömt, und eine Flüssigkeitsleitung aufweist, durch die kondensiertes und verflüssigtes Flüssigphasen-Kältemittel strömt:
**dadurch gekennzeichnet, dass**
das Kondensationsmittel ein erstes Kondensationsmittel und ein zweites Kondensationsmittel aufweist, die sich in der Kondensationsmittelhöhe unterscheiden, die als die Höhe in die vertikale Richtung eines Kondensationsbehälters definiert ist, der das Kondensationsmittel bildet, und die Kondensationsmittelhöhe des ersten Kondensationsmittels so konfiguriert ist, dass sie größer als die Kondensationsmittelhöhe des zweiten Kondensationsmittels ist;
das erste Kondensationsmittel einen Dampfleitungsverbindungsabschnitt aufweist, der mit der Dampfleitung an der Position oberhalb der Kondensationsmittelhöhe des zweiten Kondensationsmittels in die vertikale Richtung verbunden ist; und
das Durchflussregelmittel im oberen Teil des zweiten Kondensationsmittels angeordnet ist.

2. Kühlvorrichtung nach Anspruch 1,
wobei das Durchflussregelmittel mehrere dünne Durchflussregelplatten mit stehenden rechteckig geformten dünnen Platten aufweist, und
eine Erstreckungsrichtung der dünnen Durchflussregelplatten gegenüber einer Zuflussrichtung der Luft geneigt ist, die in das Kondensationsmittel strömt.

3. Kühlvorrichtung nach Anspruch 1 oder 2,
wobei die Dampfleitung mit dem Verdampfungsbehälter an einer Position verbunden ist, die höher oder gleich der Höhe des Trennwandmittels ist, und
die Flüssigkeitsleitung mit dem Verdampfungsbehälter an einer Position verbunden ist, die niedriger oder gleich der Höhe der Dampf-Flüssigkeits-Grenzfläche des Kältemittels ist.

4. Kühlvorrichtung nach einem der Ansprüche 1, 2 und 3,
wobei das Trennwandmittel mehrere dünne Trennwandplatten mit stehenden rechteckig geformten dünnen Platten aufweist.

5. Kühlvorrichtung nach einem der Ansprüche 1, 2, 3 und 4,
wobei das Kondensationsmittel zum Beschleunigen der Wärmeabstrahlung des Dampfphasen-Kältemittels Kondensationsplattenmittel im Kondensationsbehälter aufweist; das Kondensationsplattenmittel mehrere dünne Kondensationsplatten mit stehenden rechteckig geformten dünnen Platten aufweist; und
die Höhe des Kondensationsplattenmittels niedriger als die Kondensationsmittelhöhe des zweiten Kondensationsmittels ist.

6. Kühlvorrichtung nach einem der Ansprüche 1, 2, 3, 4 und 5,
wobei die Flüssigkeitsleitung mit dem Kondensationsbehälter an einer Position verbunden ist, die niedriger oder gleich der Höhe der Dampf-Flüssigkeits-Grenzfläche des Kältemittels ist.

7. Kühlvorrichtung nach einem der Ansprüche 1, 2, 3, 4, 5 und 6, die ferner ein Wärmeabstrahlungsmittel aufweist, das thermisch mit dem Kondensationsmittel verbunden ist, wobei das Wärmeabstrahlungsmittel im unteren Teil des Kondensationsmittels angeordnet ist.

8. Kühlvorrichtung nach Anspruch 7,
wobei das Durchflussregelmittel mehrere dünne Durchflussregelplatten mit stehenden rechteckig geformten dünnen Platten aufweist,
das Wärmeabstrahlungsmittel mehrere dünne Wärmeabstrahlungsplatten mit stehenden rechteckig geformten dünnen Platten aufweist; und
ein Abstand zwischen den dünnen Durchflussregelplatten größer als ein Abstand zwischen den dünnen Wärmeabstrahlungsplatten ist.

9. Kühlvorrichtung nach einem der Ansprüche 1, 2, 3, 4, 5, 6, 7 und 8,
wobei eine Seitenfläche des Kondensationsbehälters an einem Grenzbereich zwischen dem ersten Kondensationsmittel und dem zweiten Kondensationsmittel gegenüber der Zuflussrichtung der Luft geneigt ist, die in das Kondensationsmittel strömt.

## Revendications

1. Dispositif de refroidissement, comprenant :
une unité d'évaporation pour le stockage d'un réfrigérant ;
une unité de condensation pour la condensation et la liquéfaction d'un réfrigérant en phase vapeur vaporisé dans l'unité d'évaporation et diffusant de la chaleur ;
une conduite reliant l'unité d'évaporation à l'unité de condensation ; et
une unité de régulation de flux pour réguler une direction du flux d'air traversant l'unité de condensation,
où l'unité d'évaporation et l'unité de condensation sont disposées sensiblement sur le même niveau dans la direction verticale ;
l'unité d'évaporation comprend un conteneur d'évaporation et un moyen de cloisonnement pour séparer le réfrigérant présent dans le conteneur d'évaporation ;
la hauteur du moyen de cloisonnement est supérieure ou égale à la hauteur d'une interface vapeur-liquide du réfrigérant et est inférieure à la hauteur du conteneur d'évaporation ;
la conduite comprend une conduite de vapeur où circule le réfrigérant en phase vapeur et une conduite de liquide où circule le réfrigérant en phase liquide condensé et liquéfié;
**caractérisé en ce que**
l'unité de condensation comprend une première unité de condensation et une deuxième unité de condensation différant par leur hauteur d'unité de condensation, laquelle est définie en tant que hauteur dans la direction verticale d'un conteneur de condensation formant l'unité de condensation, et la hauteur d'unité de condensation de la première unité de condensation est prévue pour être supérieure à la hauteur d'unité de condensation de la deuxième unité de condensation ;
la première unité de condensation comprend une section de connexion de conduite de vapeur raccordée à la conduite de vapeur à un emplacement situé au-dessus de la hauteur d'unité de condensation de la deuxième unité de condensation dans la direction verticale ; et
l'unité de régulation de flux est disposée dans la partie supérieure de la deuxième unité de condensation.

2. Dispositif de refroidissement selon la revendication 1,
où l'unité de régulation de flux comprend une pluralité de plaques minces de régulation de flux avec des plaques minces de forme rectangulaire verticales, et
une direction d'extension des plaques minces de régulation de flux est inclinée dans une direction d'admission de l'air s'écoulant dans l'unité de condensation.

3. Dispositif de refroidissement selon la revendication 1 ou la revendication 2,
où la conduite de vapeur est raccordée au conteneur d'évaporation à un emplacement situé au-dessus, ou à la hauteur du moyen de cloisonnement, et
la conduite de liquide est raccordée au conteneur d'évaporation à un emplacement situé en dessous, ou à la hauteur de l'interface vapeur-liquide du réfrigérant.

4. Dispositif de refroidissement selon l'une des revendications 1 à 3,
où le moyen de cloisonnement comprend une pluralité de plaques de cloisonnement minces avec des plaques minces de forme rectangulaire verticales.

5. Dispositif de refroidissement selon l'une des revendications 1 à 4,
où l'unité de condensation comprend un moyen à plaques de condensation pour activer le rayonnement thermique du réfrigérant en phase vapeur dans le conteneur de condensation ;
le moyen à plaques de condensation comprend une pluralité de plaques minces de condensation avec des plaques minces de forme rectangulaire verticales ; et
la hauteur du moyen à plaques de condensation est inférieure à la hauteur d'unité de condensation de la deuxième unité de condensation.

6. Dispositif de refroidissement selon l'une des revendications 1 à 5, où la conduite de liquide est raccordée au conteneur de condensation à un emplacement situé en dessous, ou à la hauteur de l'interface vapeur-liquide du réfrigérant

7. Dispositif de refroidissement selon l'une des revendications 1 à 6, comprenant en outre une unité de rayonnement thermique reliée thermiquement à l'unité de condensation, ladite unité de rayonnement thermique étant disposée dans la partie inférieure de l'unité de condensation.

8. Dispositif de refroidissement selon la revendication 7,
où l'unité de régulation de flux comprend une pluralité de plaques minces de régulation de flux avec des plaques de forme rectangulaire verticales,
l'unité de rayonnement thermique comprend une pluralité de plaques minces de rayonnement thermique avec des plaques de forme rectangulaire verticales ; et
la distance entre les plaques minces de régulation de flux est supérieure à la distance entre les plaques minces de rayonnement thermique.

9. Dispositif de refroidissement selon l'une des revendications 1 à 8,
où une surface latérale du conteneur de condensation dans une zone limite entre la première unité de condensation et la deuxième unité de condensation est inclinée dans la direction d'admission de l'air s'écoulant dans l'unité de condensation.
